(19) Europäisches Patentamt
European Patent Office
Office européen des brevets

(11) **EP 1 870 991 B1**

(12) **EUROPÄISCHE PATENTSCHRIFT**

(45) Veröffentlichungstag und Bekanntmachung des Hinweises auf die Patenterteilung:
**15.01.2014   Patentblatt 2014/03**

(51) Int Cl.:
**H02M 1/32** *(2007.01)*        **G01R 29/16** *(2006.01)*
**H02J 3/18** *(2006.01)*

(21) Anmeldenummer: **06405267.3**

(22) Anmeldetag: **23.06.2006**

(54) **Verfahren zum Betrieb einer Umrichterschaltung**

Method for operating an inverter circuit

Méthode de commande d'un circuit onduleur

(84) Benannte Vertragsstaaten:
**AT BE BG CH CY CZ DE DK EE ES FI FR GB GR HU IE IS IT LI LT LU LV MC NL PL PT RO SE SI SK TR**

(43) Veröffentlichungstag der Anmeldung:
**26.12.2007   Patentblatt 2007/52**

(73) Patentinhaber: **ABB Schweiz AG**
**5400 Baden (CH)**

(72) Erfinder:
• **Conticelli, Fabio**
  **5405 Dättwil (CH)**
• **Beiser, Dirk**
  **CH-5300 Turgi (CH)**
• **Bohren, Patrick**
  **5600 Lenzburg (CH)**

(74) Vertreter: **ABB Patent Attorneys**
**C/o ABB Schweiz AG**
**Intellectual Property CH-IP**
**Brown Boveri Strasse 6**
**5400 Baden (CH)**

(56) Entgegenhaltungen:
**WO-A-2004/081591     US-A1- 2002 044 464**
**US-B1- 6 201 715**

• **CATALIOTTI A ET AL: "A time domain approach for IEEE Std 1459-2000 powers measurement in distorted and unbalanced power systems" INSTRUMENTATION AND MEASUREMENT TECHNOLOGY CONFERENCE, 2004. IMTC 04. PROCEEDINGS OF THE 21ST IEEE COMO, ITALY 18-20 MAY 2004, PISCATAWAY, NJ, USA,IEEE, US, 18. Mai 2004 (2004-05-18), Seiten 1388-1393Vol2, XP010736561 ISBN: 0-7803-8248-X**

EP 1 870 991 B1

## Beschreibung

### Technisches Gebiet

Die Erfindung bezieht sich auf das Gebiet der Leistungselektronik. Sie geht aus von einem Verfahren zum Betrieb einer Umrichterschaltung gemäss dem Oberbegriff des unabhängigen Anspruchs.

### Stand der Technik

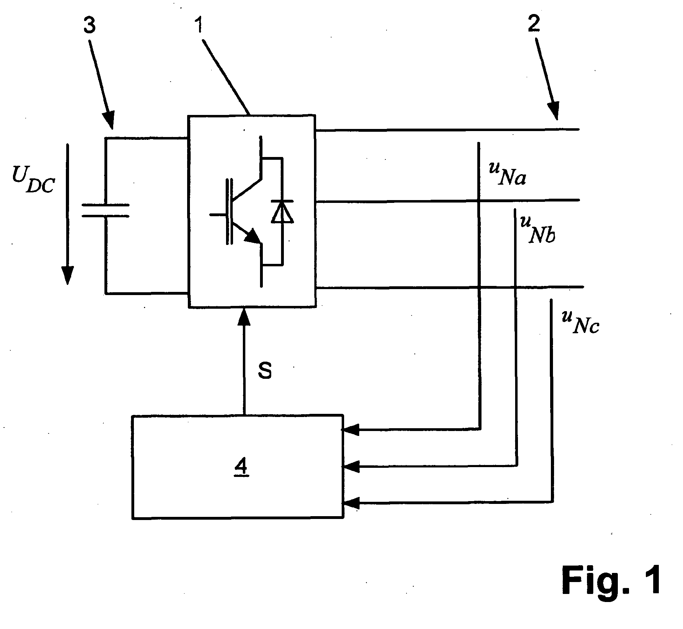

Herkömmliche Umrichterschaltungen umfassen eine Umrichtereinheit mit einer Vielzahl an ansteuerbaren Leistungshalbleiterschaltern, welche in bekannter Weise zur Schaltung von mindestens zwei Schaltspannungsniveaus verschaltet sind. Eine derartige Umrichterschaltung ist in Fig. 1 gezeigt. Wechselspannungsseitig ist die Umrichtereinheit 1 mit einem elektrischen Wechselspannungsnetz 2 verbunden. Ferner ist ein kapazitiver Energiespeicher 3 mit der Umrichtereinheit 1 verbunden, welcher gängigerweise durch einen oder mehrere Kondensatoren gebildet ist. Für den Betrieb der Umrichterschaltung ist typischerweise eine Ansteuervorrichtung 4 vorgesehen, welche verfahrensmässig beim Betrieb der Umrichterschaltung die ansteuerbaren Leistungshalbleiterschalter mittels eines Ansteuersignals S angesteuert, wobei dass Ansteuersignal S insbesondere im Falle des Normalbetriebes der Umrichterschaltung mittels einer Zuordnungstabelle (look-up table), bei welcher Referenzwerten entsprechende Ansteuersignale fest zugeordnet sind, oder mittels eines Modulators, welcher auf der Pulsweitenmodulation basiert, generiert wird.

Problematisch bei einer derartigen Umrichterschaltung ist, dass bei unsymmetrischen Phasenspannungen $U_{Na}$, $U_{Nb}$, $U_{Nc}$ des Wechselspannungsnetzes 2, d.h. bei unterschiedlichen Phasenwinkeln der Phasenspannungen $U_{Na}$, $U_{Nb}$, $U_{Nc}$ zueinander und/oder bei unterschiedlichen Amplituden der Phasenspannungen $U_{Na}$, $U_{Nb}$, $U_{Nc}$ zueinander und/oder bei unterschiedlichen Frequenzen der Phasenspannungen $U_{Na}$, $U_{Nb}$, $U_{Nc}$ zueinander, die Leistungshalbleiterschalter der Umrichtereinheit beschädigt oder gar zerstört werden können, da bei einer solchen Unsymmetrie beispielsweise unerwünschte Ströme über die Leistungshalbleiter fliessen. Die Verfügbarkeit der Umrichterschaltung sinkt dadurch massiv und die Wartung der Umrichterschaltung erhöht sich signifikant.

Die US 200210044464 A 1 betrifft ein Verfahren und ein System zur Detektion bzw. Ermittlung einer negativen Sequenz der Phasenströme eines dreiphasigen Wechselspannungsnetzes.

Die US 6,201, 715 B 1 offenbart ein System, wobei die Phasenspannungen eines dreiphasigen Wechselspannungsnetzes ermittelt werden und eine Reglereinheit die positive Sequenz eines Park-Vektors der Phasenspannungen des Wechselspannungsnetzes extrahiert, wobei ausschliesslich diese positive Sequenz zur Regelung einer mit dem dreiphasigen Wechselspannungsnetz verbundenen Umrichtereinheit verwendet wird.

Die WO 20041081591 A 1 betrifft ein Verfahren zur Bestimmung einer negativen Sequenz der Phasenspannungen eines dreiphasigen elektrischen Wechselspannungsnetzes.

Die Publikation "A time domain approach for IEEE Std 1459-2000 powers measurement in distorted and unbalanced power System", IMTC 2004 gibt einen Ansatz im Zeitbereich zur Detektion von Grundschwingung und Oberschwingungen in Phasenspannungen eines dreiphasigen elektrischen Wechselspannungsnetzes an.

### Darstellung der Erfindung

Aufgabe der Erfindung ist es deshalb, ein Verfahren zum Betrieb einer Umrichterschaltung anzugeben, mittels welchem die Umrichterschaltung bei auftretenden unsymmetrischen Phasenspannungen eines mit der Umrichterschaltung verbundenen Wechselspannungsnetzes geschützt werden kann.

Beim erfindungsgemässen Verfahren zum Betrieb einer Umrichterschaltung weist die Umrichterschaltung eine Umrichtereinheit mit einer Vielzahl an ansteuerbaren Leistungshalbleiterschaltern auf, wobei die Umrichtereinheit wechselspannungsseitig mit einem elektrischen Wechselspannungsnetz verbunden ist und die ansteuerbaren Leistungshalbleiterschalter mittels eines Ansteuersignals angesteuert werden. Erfindungsgemäss werden nun zunächst die Phasenspannungen des Wechselspannungsnetzes, insbesondere durch Messung, ermittelt. Danach werden die Amplitude der negativen Sequenz der Phasenspannungen sowie die Amplitude der Park-Clarke-Transformation der Phasenspannungen berechnet. Weiterhin wird die Amplitude der negativen Sequenz der Phasenspannungen auf einen einstellbaren Wert hin überwacht und die Amplitude der Park-Clarke-Transformation der Phasenspannungen wird auf einen einstellbaren Wert hin überwacht. Falls die Amplitude der negativen Sequenz der Phasenspannungen den einstellbaren Wert überschreitet oder falls die Amplitude der Park-Clarke-Transformation der Phasenspannungen den einstellbaren Wert unterschreitet, werden die ansteuerbaren Leistungshalbleiterschalter mittels des Ansteuersignals gesperrt. Durch die Überwachung der Amplitude der negativen Sequenz der Phasenspannungen und der Amplitude der Park-Clarke-Transformation der Phasenspannungen kann eine Unsymmetrie der Phasenspannungen in sehr einfacher Weise detektiert werden, ohne dass jede einzelne Phasenspannung, beispielsweise bezüglich ihre Amplitude, ihres Phasenwinkels und/oder ihrer Frequenz überwacht werden muss. Damit kann der Überwachungsaufwand sehr gering gehalten werden, da lediglich zwei Grössen, nämlich die Amplitude der negativen Sequenz der Phasenspannungen und die Amplitude der Park-Clarke-Transformation der Phasenspannungen, überwacht werden müssen. Weiterhin kann die Umrichterschaltung durch dass Sperren der ansteuerbaren Leistungshalbleiterschalter der Umrichtereinheit in den vorstehend genannten Fällen vorteilhaft in einen sicheren Zustand versetzt werden, so dass die Leistungshalbleiterschalter der Umrichtereinheit vor Beschädigung oder Zerstörung geschützt werden. Dadurch ist die Umrichterschaltung gegenüber auftretenden unsymmetrischen Phasenspannungen des Wechselspannungsnetzes sehr robust, wobei zudem mit Vorteil eine hohe Verfügbarkeit der Umrichterschaltung bei gleichzeitig geringem Wartungsaufwand erreicht werden kann.

Diese und weitere Aufgaben, Vorteile und Merkmale der vorliegenden Erfindung werden aus der nachfolgenden detaillierten Beschreibung bevorzugter Ausführungsformen der Erfindung in Verbindung mit der Zeichnung offensichtlich.

## Kurze Beschreibung der Zeichnungen

Es zeigt:

Fig. 1    eine gängige Ausführungsform einer Umrichterschaltung, welche mit dem erfindungsgemässen Verfahren betrieben wird.

Die in der Zeichnung verwendeten Bezugszeichen und deren Bedeutung sind in der Bezugszeichenliste zusammengefasst aufgelistet. Grundsätzlich sind in der Figur gleiche Teile mit gleichen Bezugszeichen versehen. Die beschriebene Ausführungsform ist als Beispiel zu verstehen hat keine beschränkende Wirkung.

## Wege zur Ausführung der Erfindung

Eine gängige Ausführungsform einer Umrichterschaltung ist in Fig. 1 gezeigt. Die Umrichterschaltung umfasst eine Umrichtereinheit 1 zur Schaltung von mindestens zwei Schaltspannungsniveaus. Wechselspannungsseitig ist die Umrichtereinheit 1 mit einem elektrischen Wechselspannungsnetz 2 verbunden. Desweiteren ist ein kapazitiver Energiespeicher 3 mit der Umrichtereinheit 1 verbunden, welcher typischerweise durch einen oder mehrere Kondensatoren gebildet ist. Für den Betrieb der Umrichterschaltung ist eine Ansteuervorrichtung 4 vorgesehen, welche verfahrensmässig beim Betrieb der Umrichterschaltung die ansteuerbaren Leistungshalbleiterschalter mittels eines Ansteuersignals S angesteuert, wobei dass Ansteuersignal S insbesondere im Falle des Normalbetriebes der Umrichterschaltung mittels einer Zuordnungstabelle (look-up table), bei welcher Referenzwerten entsprechende Ansteuersignalwerte fest zugeordnet sind, oder mittels eines Modulators, welcher auf der Pulsweitenmodulation basiert, generiert wird.

Bezüglich des erfindungsgemässen Verfahrens zum Betrieb einer solchen Umrichterschaltung werden zunächst die Phasenspannungen $U_{Na}$, $U_{Nb}$, $U_{Nc}$ des Wechselspannungsnetzes 2 ermittelt, was vorzugsweise durch Messung geschieht. Zudem werden die Amplitude der negativen Sequenz der Phasenspannungen $U_{Nn,A}$ sowie die Amplitude der Park-Clarke-Transformation der Phasenspannungen $U_{Ndq,A}$ berechnet. Auf die Berechnung der Amplitude der negativen Sequenz der Phasenspannungen $U_{Nn,A}$ und auf die Berechnung der Amplitude der Park-Clarke-Transformation der Phasenspannungen $U_{Ndq,A}$ wird nachfolgend noch detailliert eingegangen. Weiterhin wird die Amplitude der negativen Sequenz der Phasenspannungen $U_{Nn,A}$ auf einen einstellbaren Wert hin überwacht, wobei die Amplitude der Park-Clarke-Transformation der Phasenspannungen $U_{Ndq,A}$ ebenfalls auf einen einstellbaren Wert hin überwacht wird. Falls die Amplitude der negativen Sequenz der Phasenspannungen $U_{Nn,A}$ den einstellbaren Wert überschreitet oder falls die Amplitude der Park-Clarke-Transformation der Phasenspannungen $U_{Ndq,A}$ den einstellbaren Wert unterschreitet, werden die ansteuerbaren Leistungshalbleiterschalter mittels des Ansteuersignals S gesperrt. Mit Hilfe der Überwachung der Amplitude der negativen Sequenz der Phasenspannungen $U_{Nn,A}$ und der Amplitude der Park-Clarke-Transformation der Phasenspannungen $U_{Ndq,A}$ kann eine Unsymmetrie der Phasenspannungen $U_{Na}$, $U_{Nb}$, $U_{Nc}$ problemlos detektiert werden, ohne dass jede einzelne Phasenspannung $U_{Na}$, $U_{Nb}$, $U_{Nc}$ beispielsweise bezüglich ihre Amplitude, ihres Phasenwinkels und/oder ihrer Frequenz überwacht werden muss. Damit kann der Überwachungsaufwand sehr gering gehalten werden, da lediglich zwei Grössen, nämlich die Amplitude der negativen Sequenz der Phasenspannungen $U_{Nn,A}$ und die Amplitude der Park-Clarke-Transformation der Phasenspannungen $U_{Ndq,A}$, überwacht werden müssen. Weiterhin kann die Umrichterschaltung durch dass Sperren der ansteuerbaren Leistungshalbleiterschalter der Umrichtereinheit 1 in den vorstehend genannten Fällen vorteilhaft in einen sicheren Zustand versetzt werden, so dass die Leistungshalbleiterschalter der Umrichtereinheit 1 vor Beschädigung oder Zerstörung geschützt werden. Dadurch ist die Umrichterschaltung gegenüber auftretenden unsymmetrischen Phasenspannungen $U_{Na}$, $U_{Nb}$, $U_{Nc}$ des Wechselspannungsnetzes 2 sehr robust, wobei zusätzlich mit Vorteil eine hohe Verfügbarkeit der Umrichterschaltung bei gleichzeitig geringem Wartungsaufwand erreicht werden kann.

Die Phasenspannungen $U_{Na}$, $U_{Nb}$, $U_{Nc}$ sind definiert wie folgt:

$$U_{Na} = U_{Na,A} \cdot \sin(\omega t)$$

$$U_{Nb} = U_{Nb,A} \cdot \sin\left(\omega t - \frac{2\pi}{3}\right)$$

$$U_{Nc} = U_{Nc,A} \cdot \sin\left(\omega t - \frac{4\pi}{3}\right),$$

wobei $\omega = 2\pi F_{nom}$ ist und $F_{nom}$ die Nominalfrequenz des elektrischen Wechselspannungsnetzes 2 ist, beispielsweise $F_{nom}=50$ Hz bei einem gängigen elektrischen Verbundwechselspannungsnetz oder $F_{nom}=16$ 2/3Hz bei einem elektrischen Bahnwechselspannungsnetz. Zur Ermittlung des Phasenwinkels wt umfasst die Ansteuervorrichtung 4 vorzugsweise einen Phasenregelkreis (Phase locked loop).

Die d-Komponente der Park-Clarke-Transformation der Phasenspannungen $U_{Nd}$ und die q-Komponente der Park-Clarke-Transformation der Phasenspannungen $U_{Nq}$ ergeben sich dann zu

$$U_{Nd} = U_{Na} \cdot \cos(\omega t) + \frac{1}{\sqrt{3}} \cdot (U_{Nb} - U_{Nc}) \cdot \sin(\omega t)$$

$$U_{Nq} = -U_{Na} \cdot \sin(\omega t) + \frac{1}{\sqrt{3}} \cdot (U_{Nb} - U_{Nc}) \cdot \cos(\omega t)$$

Die Amplitude der Park-Clarke-Transformation der Phasenspannungen $U_{Ndq,A}$ berechnet sich mit den vorstehend genannten Formeln wie folgt zu

$$U_{Ndq,A} = \sqrt{U_{Nd}^2 + U_{Nq}^2}$$

Im Falle von unsymmetrischen Phasenspannungen $U_{Na}$, $U_{Nb}$, $U_{Nc}$, können diese unsymmetrischen Phasenspannungen $U_{Na}$, $U_{Nb}$, $U_{Nc}$, in eine positive Sequenz der Phasenspannungen $U_{Np}$ und in eine negative Sequenz der Phasenspannungen $U_{Nn}$ zerlegt werden, die sich dann allgemein wie folgt ergeben zu

$$U_{Np} = U_{Ndp} + jU_{Nqp}$$

$$U_{Nn} = U_{Cr} \cdot e^{j2\omega t}$$

mit

$$U_{Ndp} = U_{Nd} - \mathrm{Re}(U_{Cr})$$

$$U_{Nqp} = U_{Nq} - \mathrm{Im}(U_{Cr})$$

$$U_{Cr} = \left(\frac{U_{Nd} - U_{Ndt1}}{2 \cdot \sin(\omega t1)} + j\frac{U_{Nq} - U_{Nqt1}}{2 \cdot \sin(\omega t1)}\right) \cdot e^{j\left(\frac{\pi}{2} - \omega t1\right)},$$

wobei $U_{Ndt1}$ die um die Zeitdauer t1 verzögerte d-Komponente der Park-Clarke-Transformation der Phasenspannungen $U_{Nd}$ ist und $U_{Nqt1}$ die um die Zeitdauer t1 verzögerte q-Komponente der Park-Clarke-Transformation der Phasenspannungen $U_{Nq}$ ist. Vorzugsweise wird die Zeitdauer t1 in der Grössenordnung von $t1 = \dfrac{1}{4} \cdot \dfrac{1}{F_{nom}}$ gewählt. Bei der negativen

Sequenz der Phasenspannungen $U_{Nn}$ handelt es sich insbesondere um eine Abschätzung im Park-Clarke-Bezugssystem (dq-Bezugssystem) mit einer Winkelgeschwindigkeit -$\omega$.

Die Amplitude der negativen Sequenz der Phasenspannungen $U_{Nn,A}$ berechnet sich mit den vorstehend genannten Formeln wie folgt zu

$$U_{Nn,A} = |U_{Nn}| = |U_{Cr} \cdot e^{j2\omega t}| = \left|\left(\frac{U_{Nd} - U_{Ndt1}}{2 \cdot \sin(\omega t1)} + j\frac{U_{Nq} - U_{Nqt1}}{2 \cdot \sin(\omega t1)}\right) \cdot e^{j\left(\frac{\pi}{2} - \omega t1\right)}\right) \cdot e^{j2\omega t}\right|$$

Zur Berechnung der Amplitude der negativen Sequenz der Phasenspannungen $U_{Nn,A}$ sowie zu Berechnung der Amplitude die Amplitude der Park-Clarke-Transformation der Phasenspannungen $U_{Ndq,A}$ umfasst die Ansteuervorrichtung 4 vorzugsweise eine Berechnungseinheit, welche die entsprechenden Berechnungen gemäss den vorstehend genannten Formeln durchführt.

Die Ermittlung der Phasenspannungen $U_{Na}$, $U_{Nb}$, $U_{Nc}$ des Wechselspannungsnetzes 2 erfolgt vorzugsweise fortlaufend, so dass stets mit aktuellsten Werten gerechnet werden kann. Weiterhin erfolgt die Berechnung der Amplitude der negativen Sequenz der Phasenspannungen $U_{Nn,A}$ sowie die Berechnung der Amplitude der Park-Clarke-Transformation der Phasenspannungen $U_{Ndq,A}$ ebenfalls fortlaufend, wodurch immer die aktuellsten Werte der Amplitude der negativen Sequenz der Phasenspannungen $U_{Nn,A}$ und der Amplitude der Park-Clarke-Transformation der Phasenspannungen $U_{Ndq,A}$ vorliegen. Auch die Überwachung der Amplitude der negativen Sequenz der Phasenspannungen $U_{Nn,A}$ auf den zugehörigen einstellbaren Wert hin und die Überwachung der Amplitude der Park-Clarke-Transformation der Phasenspannungen $U_{Ndq,A}$ auf den zugehörigen einstellbaren Wert hin erfolgt vorzugsweise fortlaufend, so dass stets schnell auf eine auftretende Unsymmetrie der Phasenspannungen $U_{Na}$, $U_{Nb}$, $U_{Nc}$ oder auf einen entsprechend den vorstehend beschriebenen Massnahmen des erfindungsgemässen Verfahrens reagiert werden kann. Ebenso kann auf einen Rückgang der Unsymmetrie der Phasenspannungen $U_{Na}$, $U_{Nb}$, $U_{Nc}$ entsprechend den nachfolgend noch detailliert beschriebenen Massnahmen des erfindungsgemässen Verfahrens reagiert werden.

Bei Rückgang der Unsymmetrie der Phasenspannungen $U_{Na}$, $U_{Nb}$, $U_{Nc}$ bzw. falls die Unsymmetrie nur noch unwesentlich vorhanden ist, kann dieser Rückgang der Unsymmetrie der Phasenspannungen $U_{Na}$, $U_{Nb}$, $U_{Nc}$ bzw. die Quasi-Symmetrie der Phasenspannungen $U_{Na}$, $U_{Nb}$, $U_{Nc}$ mittels der Überwachung der Amplitude der negativen Sequenz der Phasenspannungen $U_{Nn,A}$ auf den zugehörigen einstellbaren Wert hin und mittels der Überwachung der Amplitude der Park-Clarke-Transformation der Phasenspannungen $U_{Ndq,A}$ auf den zugehörigen einstellbaren Wert hin ebenfalls sehr einfach und damit problemlos detektiert werden. Falls dann die Amplitude der negativen Sequenz der Phasenspannungen $U_{Nn,A}$ den einstellbaren Wert wieder unterschreitet und falls die Amplitude der Park-Clarke-Transformation der Phasenspannungen $U_{Ndq,A}$ den einstellbaren Wert wieder überschreitet, werden die ansteuerbaren Leistungshalbleiterschalter der Umrichtereinheit 1 mittels des Ansteuersignals S wieder entsperrt, so dass die Umrichterschaltung wieder im Normalbetrieb arbeiten kann. Die Umrichterschaltung ist damit schnellstmöglich wieder am elektrischen Wechselspannungsnetz 2 einsetzbar und weist damit eine weiter verbesserte Verfügbarkeit auf.

**Bezugszeichenliste**

1　Umrichtereinheit
2　elektrisches Wechselspannungsnetz
3　kapazitiver Energiespeicher

4    Ansteuervorrichtung

**Patentansprüche**

**1.** Verfahren zum Betrieb einer Umrichterschaltung, wobei die Umrichterschaltung eine Umrichtereinheit (1) mit einer Vielzahl an ansteuerbaren Leistungshalbleiterschaltern aufweist und die Umrichtereinheit (1) wechselspannungsseitig mit einem elektrischen Wechselspannungsnetz (2) verbunden ist,
bei dem die ansteuerbaren Leistungshalbleiterschaltet mittels eines Ansteuersignals (S) angesteuert werden und die Phasenspannungen ($U_{Na}$, $U_{Nb}$, $U_{Nc}$) des Wechselspannungsnetzes (2) ermittelt werden,
**dadurch gekennzeichnet,**
**dass** die Amplitude der negativen Sequenz der Phasenspannungen ($U_{Nn,A}$) berechnet wird,
**dass** die Amplitude der Park-Clarke-Transformation der Phasenspannungen ($U_{Ndq,A}$) berechnet wird,
**dass** die Amplitude der negativen Sequenz der Phasenspannungen ($U_{Nn,A}$) auf einen einstellbaren Wert hin überwacht wird,
**dass** die Amplitude der Park-Clarke-Transformation der Phasenspannungen ($U_{Ndq,A}$) auf einen einstellbaren Wert hin überwacht wird,
**dass** die ansteuerbaren Leistungshalbleiterschalter mittels des Ansteuersignals (S) gesperrt werden, falls die Amplitude der negativen Sequenz der Phasenspannungen ($U_{Nn,A}$) den einstellbaren Wert überschreitet oder
falls die Amplitude der Park-Clarke-Transformation der Phasenspannungen ($U_{Ndq,A}$) den einstellbaren Wert unterschreitet.

**2.** Verfahren nach Anspruch 1, **dadurch gekennzeichnet, dass** die ansteuerbaren Leistungshalbleiterschalter mittels des Ansteuersignals (S) entsperrt werden, falls die Amplitude der negativen Sequenz der Phasenspannungen ($U_{Nn,A}$) den einstellbaren Wert wieder unterschreitet und
falls die Amplitude der Park-Clarke-Transformation der Phasenspannungen ($U_{Ndq,A}$) den einstellbaren Wert wieder überschreitet.

**3.** Verfahren nach Anspruch 1 oder 2, **dadurch gekennzeichnet, dass** die Ermittlung der Phasenspannungen ($U_{Na}$, $U_{Nb}$, $U_{Nc}$) des Wechselspannungsnetzes (2) fortlaufend erfolgt.

**4.** Verfahren nach einem der Ansprüche 1 bis 3, **dadurch gekennzeichnet, dass** die Berechnung der Amplitude der negativen Sequenz der Phasenspannungen ($U_{Nn,A}$) fortlaufend erfolgt.

**5.** Verfahren nach einem der Ansprüche 1 bis 4, **dadurch gekennzeichnet, dass** die Berechnung der Amplitude der Park-Clarke-Transformation der Phasenspannungen ($U_{Ndq,A}$) fortlaufend erfolgt.

**6.** Verfahren nach einem der Ansprüche 1 bis 5, **dadurch gekennzeichnet, dass** die Überwachung der Amplitude der negativen Sequenz der Phasenspannungen ($U_{Nn,A}$) auf den einstellbaren Wert hin fortlaufend erfolgt.

**7.** Verfahren nach einem der Ansprüche 1 bis 6, **dadurch gekennzeichnet, dass** die Überwachung der Amplitude der Park-Clarke-Transformation der Phasenspannungen ($U_{Ndq,A}$) auf den einstellbaren Wert hin fortlaufend erfolgt.

**Claims**

**1.** Method for operating a converter circuit, wherein the converter circuit comprises a converter unit (1) having a multiplicity of controllable power semiconductor switches and the converter unit (1) is connected to an electrical AC voltage power supply system (2) on the AC voltage side,
wherein the controllable power semiconductor switches are controlled by means of a control signal (S) and the phase voltages ($U_{Na}$, $U_{Nb}$, $U_{Nc}$) of the AC voltage power supply system (2) are determined,
**characterized**
**in that** the amplitude of the negative sequence of the phase voltages ($U_{Nn,A}$) is calculated,
**in that** the amplitude of the Park-Clarke transformation of the phase voltages ($U_{Ndq,A}$) is calculated,
**in that** the amplitude of the negative sequence of the phase voltages ($U_{Nn,A}$) is monitored with regard to an adjustable value,
**in that** the amplitude of the Park-Clarke transformation of the phase voltages ($U_{Ndq,A}$) is monitored with regard to an adjustable value,

**in that** the controllable power semiconductor switches are turned off by means of the control signal (S) if the amplitude of the negative sequence of the phase voltages ($U_{Nn,A}$) exceeds the adjustable value or if the amplitude of the Park-Clarke transformation of the phase voltages ($U_{Nq,A}$) falls below the adjustable value.

2. Method according to Claim 1, **characterized in that** the controllable power semiconductor switches are turned on by means of the control signal (S) if the amplitude of the negative sequence of the phase voltages ($U_{Nn,A}$) falls below the adjustable value again and if the amplitude of the Park-Clarke transformation of the phase voltages ($U_{Ndq,A}$) exceeds the adjustable value again.

3. Method according to Claim 1 or 2, **characterized in that** the determination of the phase voltages ($U_{Na}$, $U_{Nb}$, $U_{Nc}$) of the AC voltage power supply system (2) is effected continuously.

4. Method according to any of Claims 1 to 3, **characterized in that** the calculation of the amplitude of the negative sequence of the phase voltages ($U_{Nn,A}$) is effected continuously.

5. Method according to any of Claims 1 to 4, **characterized in that** the calculation of the amplitude of the Park-Clarke transformation of the phase voltages ($U_{Ndq,A}$) is effected continuously.

6. Method according to any of Claims 1 to 5, **characterized in that** the monitoring of the amplitude of the negative sequence of the phase voltages ($U_{Nn,A}$) with regard to the adjustable value is effected continuously.

7. Method according to any of Claims 1 to 6, **characterized in that** the monitoring of the amplitude of the Park-Clarke transformation of the phase voltages ($U_{Ndq,A}$) with regard to the adjustable value is effected continuously.

## Revendications

1. Procédé de conduite d'un circuit onduleur, le circuit onduleur présentant une unité d'onduleur (1) qui présente plusieurs commutateurs semi-conducteurs asservis, l'unité d'onduleur (1) étant raccordée du côté de sa tension alternative à un réseau électrique (2) à tension alternative, les commutateurs semi-conducteurs asservis étant commandés par un signal de commande (S) et les tensions de phase ($U_{Na}$, $U_{Nb}$, $U_{Nc}$) du réseau (2) à tension alternative étant déterminés, **caractérisé en ce que** l'amplitude de la séquence négative des tensions de phase ($U_{Nn,A}$) est calculée, **en ce que** l'amplitude de la transformation de Park-Clarke des tensions de phase ($U_{Ndq,A}$) est calculée, **en ce que** l'amplitude de la séquence négative des tensions de phase ($U_{Nn,A}$) est surveillée par rapport à une valeur réglable, **en ce que** l'amplitude de la transformation de Park-Clarke des tensions de phase ($U_{Ndq,A}$) est surveillée par rapport à une valeur réglable, **en ce que** les commutateurs semi-conducteurs asservis sont bloqués au moyen du signal de commande (S) au cas où l'amplitude de la séquence négative des tensions de phase ($U_{Nn,A}$) dépasse la valeur réglable ou au cas où l'amplitude de la transformation de Park-Clarke des tensions de phase ($U_{Ndq,A}$) n'atteint pas la valeur réglable.

2. Procédé selon la revendication 1, **caractérisé en ce que** les commutateurs semi-conducteurs asservis sont débloqués au moyen du signal de commande (S) au cas où l'amplitude de la séquence négative des tensions de phase ($U_{Nn,A}$) n'atteint de nouveau plus la valeur réglable et au cas où l'amplitude de la transformation de Park-Clarke des tensions de phase ($U_{Ndq,A}$) dépasse de nouveau la valeur réglable.

3. Procédé selon les revendications 1 ou 2, **caractérisé en ce que** la détermination des tensions de phase ($U_{Na}$, $U_{Nb}$, $U_{Nc}$) du réseau (2) à tension alternative s'effectue en permanence.

4. Procédé selon l'une des revendications 1 à 3, **caractérisé en ce que** le calcul de l'amplitude de la séquence négative des tensions de phase ($U_{Nn,A}$) s'effectue en permanence.

5. Procédé selon l'une des revendications 1 à 4, **caractérisé en ce que** le calcul de l'amplitude de la transformation de Park-Clarke des tensions de phase ($U_{Ndq,A}$) s'effectue en permanence.

**6.** Procédé selon l'une des revendications 1 à 5, **caractérisé en ce que** la surveillance de l'amplitude de la séquence négative des tensions de phase ($U_{Nn,A}$) par rapport à la valeur réglable s'effectue en permanence.

**7.** Procédé selon l'une des revendications 1 à 6, **caractérisé en ce que** la surveillance de l'amplitude de la transformation de Park-Clarke des tensions de phase ($U_{Ndq,A}$) par rapport à la valeur réglable s'effectue en permanence.

**Fig. 1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 200210044464 A1
- US 6201715 B1

- WO 20041081591 A1

**In der Beschreibung aufgeführte Nicht-Patentliteratur**

- A time domain approach for IEEE Std 1459-2000 powers measurement in distorted and unbalanced power System. *IMTC,* 2004